**Europäisches Patentamt**

**European Patent Office**

**Office européen des brevets**

(19)

(11) Veröffentlichungsnummer: **0 053 708**
**B1**

(12) # EUROPÄISCHE PATENTSCHRIFT

(45) Veröffentlichungstag der Patentschrift:
**02.10.85**

(51) Int. Cl.⁴: **G 03 F 7/02,** G 03 C 1/68,
G 03 F 7/20

(21) Anmeldenummer: **81109007.5**

(22) Anmeldetag: **27.10.81**

(54) Verfahren zur Herstellung von Reliefkopien.

(30) Priorität: **29.11.80 DE 3045149**

(43) Veröffentlichungstag der Anmeldung:
**16.06.82 Patentblatt 82/24**

(45) Bekanntmachung des Hinweises auf die Patenterteilung:
**02.10.85 Patentblatt 85/40**

(84) Benannte Vertragsstaaten:
**AT BE CH DE FR GB IT LI NL SE**

(56) Entgegenhaltungen:
**DD - A - 103 740**
**DE - B - 1 447 913**
**DE - B - 1 522 503**
**US - A - 3 623 869**

(73) Patentinhaber: **HOECHST AKTIENGESELLSCHAFT,**
**Postfach 80 03 20, D-6230 Frankfurt am Main 80 (DE)**

(72) Erfinder: **Horn, Klaus, Dr., Lessingstrasse 53,**
**D-6238 Hofheim (Ts) (DE)**
Erfinder: **Steppan, Hartmut, Dr., Panoramastrasse 17,**
**D-6200 Wiesbaden-Dotzheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft ein Verfahren zur Herstellung von Reliefkopien, bei dem die lichtempfindliche Schicht eines lichthärtbaren Kopiermaterials, die ein photopolymerisierbares Gemisch enthält, bildmäßig belichtet wird und die unbelichteten Schichtbereiche mittels eines Entwicklers ausgewaschen werden.

Derartige lichthärtbare Materialien, insbesondere die photopolymerisierbaren Materialien, sind nach der bildmäßigen Belichtung zumeist noch nicht vollständig ausgehärtet. Es wurde gefunden, daß in Abhängigkeit von der Wartezeit zwischen Belichtung und Entwicklung deutliche Unterschiede in der Keillänge von kopierten Halbtonstufenkeilen auftreten. Besonders ausgeprägt sind derartige Schwankungen bei der Belichtung mit Laserlicht, z. B. von einem Argon-Ionen-Laser.

Es ist bekannt, die Verarbeitung solcher und ähnlicher Materialien zu variieren. So ist in der US-PS 3 286 025 die Bebilderung von photopolymerisierbaren Materialien mit Elektronenstrahlung beschrieben. Die bestrahlte Schicht wird bevorzugt für einige Zeit erwärmt, z. B. 5 Minuten auf 136° C, um bei der dort verwendeten Schlierenprojektion zum Sichtbarmachen der Bilder einen besseren Kontrast zu ergeben. Die Empfindlichkeit der Schicht gegenüber Elektronenstrahlung wird durch das Erwärmen nicht beeinflußt.

Es ist auch bekannt, andere lichtempfindliche Systeme, die aus einer bei Belichtung eine Säure abspaltenden Verbindung und säurehärtbaren Harzen bestehen, und z. B. in den DE-PS 1 447 913 und 1 522 503 beschrieben sind, nach der Belichtung zu erwärmen, um die Durchhärtung der Harze durch die Säure zu beschleunigen.

Aufgabe der Erfindung war es, ein Verfahren der eingangs angegebenen Gattung vorzuschlagen, das es erlaubt, bei der Verarbeitung der dort genannten Materialien zu stets gleichbleibenden Ergebnissen zu kommen und mit einer geringeren Belichtung auszukommen.

Die Erfindung geht aus von einem Verfahren zur Herstellung von Reliefkopien, bei dem die photopolymerisierbare Schicht eines Aufzeichnungsmaterials, die eine photopolymerisierbare Verbindung mit mindestens zwei endständigen ethylenisch ungesättigten Doppelbindungen , ein polymeres Bindemittel und einen Photoinitiator enthält, der bei Belichtung freie Radikale zu erzeugen vermag, bildmäßig belichtet wird und danach die unbelichteten Schichtbereiche mittels eines Entwicklers ausgewaschen werden.

Das erfindungsgemäße Verfahren ist dadurch gekennzeichnet, daß man die Schicht nach dem Belichten für 5 Sekunden bis 10 Minuten auf eine Temperatur im Bereich von 50—180° C erwärmt und dann entwickelt.

Die Temperatur sollte bevorzugt zwischen 70 und 120° C liegen.

Die Dauer des Erwärmens kann vorzugsweise zwischen 5 Sekunden und 2 Minuten liegen.

Je geringer der Zeitabstand zwischen Belichtung und Erwärmen ist, desto kürzer kann die Zeitdauer des Erwärmens bemessen werden.

Das Erwärmen kann in an sich bekannter Weise z. B. durch beheizte Platten oder Walzen, durch Warmluft oder Infrarotstrahlung erfolgen.

Die nach dem erfindungsgemäßen Verfahren zu verarbeitenden lichtempfindlichen Materialien bestehen aus einer lichtempfindlichen Schicht, die sich vorzugsweise auf einem Schichtträger befindet.

Als lichtempfindliche Schichten werden photopolymerisierbare Schichten bevorzugt. Diese enthalten als wesentliche Bestandteile eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Als Photoinitiatoren eignen sich eine Vielzahl von Substanzen, beispielsweise Benzoin, Benzoinether, Mehrkernchinone, z. B. 2-Ethyl-anthrachinon; Acyridinderivate, z. B. 9-Phenyl-acridin, 9-p-Methoxyphenyl-acridin, 9-Acetylamino-acridin, Benz(a)acridin; Phenazinderivate, z. B. 9,10-Dimethyl-benz(a)phenazin, 9-Methyl-benz(a)-phenazin, 10-Methoxy-benz(a)phenazin; Chinoxalinderivate, z. B. 6,4',4''-Trimethoxy-2,3-diphenyl-chinoxalin, 4',4''-Dimethoxy-2,3-diphenyl-5-aza-chinoxalin; Chinazolinderivate; synergistische Mischungen verschiedener Ketone; Farbstoff/Redoxsysteme; Thiopyryliumsalze und dgl. mehr.

Die Photoinitiatoren werden im allgemeinen in einer Menge von 0,01 bis 10, bevorzugt von 0,2 bis 5 Gew.-%, bezogen auf die Bestandteile der photopolymerisierbaren Schicht, zugesetzt.

Für die Zwecke der Erfindung geeignete photopolymerisierbare Monomere sind bekannt und z. B. in den USA-Patentschriften 2 760 863 und 3 060 023 beschrieben.

Bevorzugte Beispiele sind Acryl- und Methacrylsäureester, wie Diglycerindiacrylat, Polyethylenglykoldimethacrylat, Acrylate und Methacrylate von Trimethylolethan, Trimethylolpropan und Pentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-OS 2 064 079 und DE-OS 2 361 041 beschrieben.

Der Mengenanteil der Schicht an Monomeren beträgt im allgemeinen etwa 10 bis 80, vorzugsweise 20 bis 60 Gew.-%.

Als Wasserstoffdonatoren werden in der Hauptsache aliphatische Polyether verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer Polymerisate Einsatz finden. Als Beispiele seien genannt: Polyamide, Polyvinylester, Polyvinylacetale, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine, Celluloseether und dgl.

Mit besonderem Vorteil werden Bindemittel verwendet, die in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: $-COOH$, $-PO_3H_2$, $-SO_3H$, $-SO_2NH_2$, $-SO_2-NH-CO-$ und dgl. Als Beispiele hierfür seien genannt: Maleinatharze, Polymerisate aus N-(p-Tolyl-sulfonyl)-carbaminsäure-($\beta$-methacryloyloxy-ethyl)-ester und Mischpolymerisate dieser und ähnlicher Monomerer mit anderen Monomeren sowie Styrol-Maleinsäureanhydrid-Mischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-OS 2 064 080 und 2 363 806 beschrieben sind, werden bevorzugt.

Die Menge des Bindemittels beträgt im allgemeinen 20 bis 90, vorzugsweise 40 bis 80 Gew.-% der Bestandteile der Schicht.

Es ist im allgemeinen günstig, die photopolymerisierbare Schicht während der Lichtpolymerisation dem Einfluß des Luftsauerstoffes weitgehend zu entziehen, d. h. vor allem die Nachdiffusion des Luftsauerstoffs in die Schicht zu verhindern. Dies ist besonders wichtig, wenn man — z. B. bei der Belichtung durch Projektion oder mit Laserstrahlung — ohne Vakuumkopierrahmen arbeitet. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.

Die Art des Schichtträgers richtet sich nach dem Verwendungszweck des lichtempfindlichen Materials. Zur Herstellung von Flachdruckplatten wird im allgemeinen Aluminium verwendet, das bevorzugt eine anodisch erzeugte poröse Oxidschicht trägt. Das Aluminium wird zweckmäßig vor dem Anodisieren mechanisch, chemisch oder elektrolytisch aufgerauht. Die Anodisierung erfolgt in bekannter Weise, z. B. in Schwefel- und/oder Phosphorsäure, vorzugsweise unter solchen Bedingungen, daß eine Oxidschicht mit einem Schichtgewicht von etwa 0,5 bis 10 $g/m^2$ erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z. B. mit Silikaten oder Polyvinylphosphonsäure. Die Beschichtung des Trägermaterials erfolgt in bekannter Weise durch Aufschleudern, Sprühen, Tauchen, mittels Wazen, Schlitzdüsen, Rakeln oder durch Gießer-Antrag.

Außer Aluminium können auch Stahl, Zink, Kupfer, verchromter Stahl oder verchromtes Kupfer, Kunststoffolien, z. B. aus Polyethylenterephthalat oder Celluloseacetat, oder Siebdruckträger, z. B. Perlongaze oder Nickelsiebe, verwendet werden.

Die Bebilderung der Kopiermaterialien erfolgt in bekannter Weise, z. B. durch Kontaktbelichtung unter einer Transparentvorlage. Dabei werden die üblichen Lichtquellen, wie Kohlenbogenlampen, Xenonlampen, mit Metallhalogeniden dotierte Quecksilberhochdrucklampen und dgl. verwendet.

Mit Vorteil kann die Bebilderung auch mit Laserlicht erfolgen, z. B. mit einem Argon-Ionen-Laser. Bei dieser Belichtungsart wird nach dem erfindungsgemäßen Verfahren eine besonders hohe Steigerung der Belichtungwirkung erzielt.

Im Rahmen des vorliegenden Verfahrens ist zur Bildbelichtung allgemein aktinisches Licht geeignet, d. h. Strahlung im Bereich des nahen Ultravioletts und des kurzwelligen sichtbaren Lichts.

Die Entwicklung der belichteten und erwärmten Kopiermaterialien erfolgt in bekannter Weise durch Auswaschen der unbelichteten Schichtbereiche mit einem Entwickler. Die Zusammensetzung des Entwicklers richtet sich nach der Natur und Löslichkeit der lichtempfindlichen Schicht. Geeignete Entwickler sind organische Lösungsmittel oder Lösungsmittelgemische, Wasser, das kleine Mengen organischer Lösungsmittel oder Netzmittel enthalten kann, und insbesondere alkalische oder schwach saure wäßrige Lösungen, die Puffersalze, Neutralsalze, organische Lösungsmittel, Netzmittel, Farbstoffe und andere übliche Zusätze enthalten können. Bevorzugt werden Entwickler, die frei von organischen Lösungsmitteln sind.

Durch die Erfindung wird erreicht, daß die Härtung der belichteten Schichtbereiche in solchem Maße gesteigert wird, daß die Belichtungszeit auf etwa die Hälfte des ohne Erhitzen Erforderlichen herabgesetzt werden kann. Bei Laserbestrahlung können noch größere Unterschiede erzielt werden. Als zusätzliche Wirkung des Erhitzens tritt eine deutlich bessere Durchhärtung der belichteten Schichtbereiche ein. Dieser Vorteil wirkt sich besonders bei der Herstellung von Druckplatten, insbesondere Flachdruckplatten, aus, bei denen von der gehärteten Bildschicht gedruckt werden soll.

Die folgenden Beispiele erläutern die Erfindung. Gewichtsteile (Gt) und Volumenteile (Vt) stehen im Verhältnis von g zu ml. Prozentangaben und Mengenverhältnisse sind, wenn nichts anderes angegeben ist, in Gewichtseinheiten zu verstehen.

## Beispiel 1

Als Schichtträger für Druckplatten wurde elektrochemisch aufgerauhtes und anodisiertes Aluminium mit einer Oxidschicht von 3 g/m$^2$ verwendet, das mit einer 0,1%igen wäßrigen Lösung von Polyvinylphosphonsäure vorbehandelt worden war. Der Träger wurde mit einer Lösung folgender Zusammensetzung überzogen:

| | |
|---|---|
| 11,7 Gt | einer 34,7%igen Lösung eines Methylmethacrylat/Methacrylsäure-Mischpolymerisats mit der Säurezahl 110 und dem mittleren Mol-Gewicht 35 000 in Methyläthylketon, |
| 2,0 Gt | des Dimethylesters der Hepta-1,6-dien-2,6-dicarbonsäure, |
| 2,0 Gt | Trimethylolethantriacrylat, |
| 0,07 Gt | 9-Phenyl-acridin, |
| 0,07 Gt | 4-Dimethylamino-4'-methyl-dibenzalaceton, |
| 0,04 Gt | eines Azofarbstoffs aus 2,4-Dinitro-6-chlor-benzoldiazoniumsalz und 2-Methoxy-5-acetylamino-N-cyanethyl-N-hydroxyethylanilin, |
| 38,0 Gt | Ethylenglykolmonoethylether, |
| 13,5 Gt | Butylacetat. |

Das Auftragen erfolgte durch Aufschleudern in der Weise, daß ein Trockengewicht von 2,8—3 g/m$^2$ erhalten wurde. Anschließend wurde die Platte 2 Minuten bei 100° C im Umlufttrockenschrank getrocknet.

Die lichtempfindliche beschichtete Platte wurde mit einr 15%igen wäßrigen Lösung von Polyvinylalkohol (12% Restacetylgruppen, K-Wert 4) beschichtet. Nach dem Trocknen wurde eine Deckschicht mit einem Gewicht von 4—5 g/m$^2$ erhalten.

Die erhaltene Druckplatte wurde mittels einer 5 kW-Metallhalogenidlampe im Abstand von 110 cm unter einem 13stufigen Belichtungskeil mit Dichteinkrementen von 0,15 30 Sekunden belichtet.

Die belichtete Platte wurde halbiert. Die eine Häfte wurde sofort entwickelt, die andere Hälfte wurde durch ein handelsübliches Erhitzungsgerät (Intercop. Gerät, Typ Secomat, der International Copying Machines Co., Hamburg), geschickt, das auf 75° C erwärmt war. Die Verweilzeit der Platte in dem Gerät betrug 7 Sekunden.

Anschließend wurden beide Plattenhälften mit einem Entwickler folgender Zusammensetzung entwickelt:

| | |
|---|---|
| 120 Gt | Natriummetasilikat × 9 H$_2$O, |
| 2,13 Gt | Strontiumchlorid, |
| 1,2 Gt | nichtiogenes Netzmittel (Kokosfettalkohol-Polyoxyethylenether mit ca. 8 Oxyethyleneinheiten), |
| 0,12 Gt | Antischaummittel, |
| 4000 Gt | vollentsalztes Wasser. |

Die Platte wurde mit 1%iger Phosphorsäure sauer gestellt und mit fetter Druckfarbe eingefärbt. Es wurden die folgenden vollvernetzten Keilstufen erhalten:

| mit Erhitzen | ohne Erhitzen |
|---|---|
| 6 | 4 |

Die Druckplatte, die vor dem Entwickeln erhitzt worden war, ergab eine Druckauflage von 220 000, die nicht erhitzte eine von 190 000 Drucken.

# 0 053 708

## Beispiel 2

Auf den in Beispiel 1 angegebenen Schichtträger wurde eine Lösung folgender Zusammensetzung so aufgeschleudert, daß ein Schichtgewicht von 3 g/m$^2$ erhalten wurde:

11,7 Gt der in Beispiel 1 angegebenen Mischpolymerisatlösung,
38,0 Gt Ethylenglykolmonoethylether,
13,5 Gt Butylacetat,
3,9 Gt des Diethylesters der Hepta-1,6-dien-2,6-dicarbonsäure,
0,07 Gt 9-Phenyl-acridin,
0,04 Gt des in Beispiel 1 angegebenen Azofarbstoffs,
0,07 Gt 4-Dimethylamino-4'-methyl-dibenzalaceton.

Die Platte wurde in gleicher Weise wie in Beispiel 1 weiterverarbeitet.
Es wurde die folgende Anzahl vollvernetzter Keilstufen erhalten:

| Erhitzen (7 Sekunden 80° C) | ohne Erhitzen |
|---|---|
| 7 | 5 |

Es wurde ein Druckversuch durchgeführt. Dazu wurde die mit fetter Farbe eingefärbte Offsetdruckplatte in eine handelsübliche Druckmaschine (Heidelberg Typ GTO) eingespannt. Nach 200 000 Drukken wurde der Druckversuch abgebrochen, obwohl noch keine Ausbrüche im 60er-Raster festzustellen waren.

Vergleichbare Ergebnisse wurden erhalten, wenn an Stelle von 9-Phenylacridin das 2,2-Dimethoxy-2-phenylacetophenon oder 2-(4-Ethoxy-napth-1-yl)-4,6-bis-trichlormethyl-s-triazin oder 2-(Acenaphth-5-yl)-4,6-bis-trichlormethyl-s-triazin verwendet wurde.

## Beispiel 3

Auf den in Beispiel 1 angegebenen Schichtträger wurde eine Lösung folgender Zusammensetzung so aufgeschleudert, daß ein Schichtgewicht von 3,5 g/m$^2$ erhalten wurde:

10,0 Gt einer 21,7%igen Lösung eines Terpolymerisates aus Styrol, n-Hexylmethacrylat und Methacrylsäure (10 : 60 : 30) mit der Säurezahl 190 in Butanon,
2,0 Gt Trimethylolethantriacrylat,
0,06 Gt 9-Phenyl-acridin und
0,03 Gt Methylviolett (C. I. 42 535) in
18,0 Gt Butanon und
7,5 Gt Butylacetat.

Die beschichtete Platte wurde anschließend 2 Minuten bei 100° C im Umlufttrockenschrank getrocknet und mit einer Deckschicht wie in Beispiel 1 versehen. Die Platte wurde unter einem 13stufigen Belichtungskeil wie in Beispiel 1 beschrieben 4, 8, 15 und 30 Sekunden belichtet und mit einem Entwickler folgender Zusammensetzung entwickelt:

5,3 Gt Natriummetasilikat × 9 H$_2$O,
3,4 Gt tert.Natriumphosphat × 12 H$_2$O,
0,3 Gt sec.Natriumphosphat,
91,0 Gt vollentsalztes Wasser.

5

Die Platte wurde mit 1%iger Phosphorsäure sauer gestellt und mit fetter Druckfarbe eingefärbt. Die Auszählung der vollvernetzten Glanzstufen ergab folgendes Bild:

| | Belichtungszeit: MH-Lampe 5 kW Sekunden | | | |
|---|---|---|---|---|
| | 4 | 8 | 15 | 30 |
| entsprechende vollvernetzte Glanzstufen | | | | |
| ohne *) | 0 | 1 | 3 | 5 |
| mit *) | 1 | 3 | 5 | 7 |

*) Erwärmen im Trockenschrank, 5 Sekunden/90°C.

Eine wie oben beschrieben hergestellte Druckplatte wurde unter einem 13stufigen Halbtonstufenkeil 30 Sekunden belichtet. Es wurden 5 Keilstufen erhalten. Eine weitere entsprechende Platte wurde 15 Sekunden belichtet und anschließend 5 Sekunden auf 90°C erwärmt. Beide Platten ergaben 5 gehärtete Keilstufen.

Die Platten wurden dann auf einer handelsüblichen Druckmaschine (Heidelberger GTO) gedruckt. Die nicht erhitzte Platte zeigte nach 150 000 Drucken bereits Ablauferscheinungen, die erhitzte Platte erst nach 200 000 Drucken.

## Beispiel 4

Eine Lösung, wie in Beispiel 3 beschrieben, wurde auf einen gereinigten Träger, der aus einem Isolierstoffmaterial mit 35 µm Kupferauflage bestand, so aufgeschleudert, daß eine Schichtdicke von ca. 5 µm erhalten wurde. Die Schicht wurde 5 Minuten bei 100°C im Umlufttrockenschrank nachgetrocknet. Anschließend wurde eine Deckschicht wie in Beispiel 1 aufgebracht. Der Beschichtungs- und Trocknungsvorgang kann auch beidseitig durchgeführt werden.

Anschließend wurde mittels einer 5-kW-MH-Lampe mit 140 cm Abstand unter einem Stufenkeil wie in Beispiel 1 beschrieben 2, 4, 8, 16, 32 und 64 Sekunden belichtet. Danach wurde von jeder Platte eine Hälfte in einem Trockenschrank 4 Minuten auf 90°C erwärmt. Alle Platten wurden dann mit 0,8%iger Sodalösung in einem Sprühprozessor zwischen 30 und 60 Sekunden entwickelt.

Es wurden die folgenden vollvernetzten Keilstufen erhalten:

| Belichtungszeit (Sekunden) | Keilstufen ohne Erwärmen | mit Erwärmen |
|---|---|---|
| 2 | 1 | 2 |
| 4 | 2 | 3 |
| 8 | 5 | 6 |
| 16 | 7 | 8 |
| 32 | 9 | 10 |
| 64 | 11 | 12 |

Wenn die vernetzbare Schicht unter einer Schaltvorlage belichtet und entwickelt wurde, waren die vernetzten Bereiche gegen die in der Leiterplattentechnik übliche Eisen-III-chlorid-Lösung resistent. Die Ätzfestigkeit war gut.

### Beispiel 5

Auf den in Beispiel 1 angegebenen Schichtträger wurde eine Lösung folgender Zusammensetzung so aufgeschleudert, daß ein Schichtgewicht von 3,5 g/m² erhalten wurde:

| | |
|---|---|
| 2,6 Gt | des Diethylesters der Hepta-1,6-dien-2,6-dicarbonsäure, |
| 6,5 Gt | eines Styrol-Maleinsäureester-Mischpolymerisats mit einer Säurezahl von 145—160 und einem Erweichungspunkt von 140—160° C, |
| 70,0 Gt | Ethylenglykolmonomethylether, |
| 0,1 Gt | 9-Phenyl-acridin, |
| 0,035 Gt | des in Beispiel 1 angegebenen Azofarbstoffs und |
| 1,0 Gt | des Umsetzungsproduktes aus 1 Mol 2,2,4-Trimethyl-hexamethylendiisocyanat und 2 Mol 2-Hydroxy-ethylmethacrylat. |

Die beschichtete Platte wurde anschließend 2 Minuten bei 100° C im Umlufttrockenschrank getrocknet und mit einer Deckschicht wie in Beispiel 1 versehen. An einem Laserite®-Gerät-150 R der Firma Eocom Corp., das mit einem Argon-Ionen-Laser ausgerüstet war, wurde die Platte mit 200 mW und 1200 L/inch = 5,3 mJ/cm² bestrahlt. Der Bildkontrast nach der Bestrahlung war gut. Anschließend wurde die Platte mit dem Entwickler von Beispiel 1 entwickelt. Die Zahl der vollvernetzten Keilstufen eines Halbtonstufenkeils betrug bei Belichtung und unmittelbar folgender Entwicklung 3.

Wenn eine gleiche Platte in gleicher Weise verarbeitet wurde, jedoch zwischen Belichten und Entwickeln in einem Erhitzungsgerät 7 Sekunden auf 80° C erhitzt wurde, so wurden 7 Keilstufen erhalten.

Andruck und Auflagendruck wurden in einer Heidelberger Offsetdruckmaschine GTO mit Dahlgren-Feuchtwerk durchgeführt und betrugen 150 000 Bogen. Bei der zwischenerhitzten Platte erhöhte sich die Auflage auf 200 000 Bogen.

### Beispiel 6

a) Auf eine elektrochemisch aufgerauhte und anodisierte Aluminiumoberfläche mit einer Oxidschicht von 3 g/m² wurde eine Lösung folgender Zusammensetzung so aufgeschleudert, daß ein Schichtgewicht von 3 g/m² erhalten wurde:

| | |
|---|---|
| 11,4 Gt | der in Beispiel 1 angegebenen Mischpolymerisatlösung, |
| 37,9 Gt | Ethylenglykolmonoethylether, |
| 13,45 Gt | Butylacetat, |
| 4,0 Gt | Trimethylolethantriacrylat, |
| 0,07 Gt | 4-Methyl-benzalchinaldin, |
| 0,08 Gt | des in Beispiel 1 angegebenen Azofarbstoffs, |
| 0,07 Gt | 4-Dimethylamino-4′-methyl-dibenzalaceton, |
| 0,56 Gt | Bisundecyldisulfid. |

Die beschichtete Platte wurde 2 Minuten im Trockenschrank bei 100° C getrocknet.

b) Eine weitere Platte wurde in gleicher Weise hergestellt und mit einer Deckschicht von 4—5 g/m² Polyvinylalkohol wie in Beispiel 1 versehen.
c) Eine dritte Platte wurde wie unter a), jedoch ohne Zusatz von Bisundecyldisulfid hergestellt.
d) Eine vierte Platte wurde wie unter c) hergestellt und mit einer Deckschicht gemäß b) versehen.

Proben der erhaltenen Offsetdruckplatten wurden mittels einer Metallhalogenidlampe von 5 kW 10, 20 und 40 Sekunden unter einem 13stufigen Belichtungskeil mit Dichteinkrementen von 0,15 belichtet.

Je eine Hälfte der unter a) bis d) beschriebenen Platten wurde direkt nach der Belichtung durch das in Beispiel 1 angegebene Erhitzungsgerät geschickt. Die Temperatur betrug 85° C, die Durchlaufzeit 7 Sekunden. Die andere Hälfte wurde jeweils nicht erwärmt.

Anschließend wurden alle Platten mit dem in Beispiel 1 beschriebenen Entwickler entwickelt.

Sie wurden dann mit 1%iger Phosphorsäure sauer gestellt und mit fetter Druckfarbe eingefärbt. Es wurde die folgende Anzahl vollvernetzter Keilstufen erhalten:

| Platte | Deck-schicht | Disulfid | Belichtungszeit (Sekunden) ohne Erwärmen | | | mit Erwärmen | | |
|---|---|---|---|---|---|---|---|---|
| | | | 10 | 20 | 40 | 10 | 20 | 40 |
| a | — | + | — | 1 | 3 | — | 1,5 | 3,5 |
| b | + | + | — | 1 | 3 | 1 | 3 | 5 |
| c | — | — | — | — | 2 | — | 1 | 3 |
| d | + | — | — | 1 | 3 | 1 | 3 | 4 |

## Beispiel 7

Eine Lösung aus

| | |
|---|---|
| 10 Gt | eines Mischpolyamids, das durch Kondensation von 33 Gt $\varepsilon$-Caprolactam, 33 Gt Hexamethylendiammoniumadipat und 33 Gt Dicyclohexylmethan-4,4'-diammoniumadipat hergestellt wurde, |
| 4 Gt | 1,3,3-Trimethyl-1-acryloylaminomethyl-5-acryloylamino-cyclohexan und |
| 0,03 Gt | Benzoinisopropylether in |
| 35 Vt | Methanol |

wurde auf eine waagerecht gelagerte Glasplatte zwischen Holzrähmchen so dick ausgegossen, daß nach restlosem Trocknen eine Folie von etwa 1 mm Dicke erhalten wurde.

Die völlig transparente Druckfolie wurde in einem Vakuumkopierrahmen durch eine kombinierte Strich-/Raster-/Schrift-Negativvorlage (Linienraster: 56 Linien/cm) 10 Minuten belichtet. Als Lichtquelle diente ein Röhrenbelichtungsgerät mit enganeinanderliegenden Leuchtstofffröhren von 40 W im Abstand von 5 cm.

Zur Entwicklung der belichteten Druckfolie wurde ein Gemisch aus 60 Vt Ethanol, 20 Vt n-Propanol und 20 Vt Wasser verwendet. Zum Entwickeln kleiner Versuchs-Druckfolien hat sich ein weicher Pinsel als geeignet erwiesen. Für etwas größere Platten wurde ein Plüschtampon verwendet.

Nach 10 Minuten Entwickeln mit dem Pinsel in dem beschriebenen Lösungsmittelgemisch wurde ein kantenscharfes Relief erhalten, welches auch die feinsten Details der Vorlage wiedergab. Die Relieftiefe betrug bei der hier angewandten Entwicklungsmethode 0,4 mm.

Wenn eine gleiche Platte nach dem Belichten 3 Minuten auf 95°C erwärmt und die Belichtungszeit auf 5 Minuten verkürzt wurde, so wurde ein gleiches bis besseres Ergebnis erhalten. Die nacherhitzten Platten wiesen eine deutlich härtere Oberfläche auf.

## Beispiel 8

Um die breite Anwendung des Verfahrens zu zeigen, wurden handelsübliche photopolymerisierbare Flachdruckplatten (Lydel®la, Du Pont und XN, 3 M Co.) 20 und 30 Sekunden unter einem Halbtonkeil belichtet und anschließend 10 Sekunden einer Wärmebehandlung von 90°C unterworfen. Danach wurden die Platten mit den von den Herstellern gelieferten Entwicklern und nach den angegebenen Vorschriften entwickelt. Vergleichsmuster ohne Temperaturbehandlung wurden direkt entwickelt.

Folgende Keilstufen wurden erhalten:

| Belichtungs-zeit (sec) | Lydel la ohne Erwärmung | mit Erwärmung | XN ohne Erwärmung | mit Erwärmung |
|---|---|---|---|---|
| 20 | 3 | 4 | 2 | 3 |
| 30 | 4 | 5 | 3 | 4 |

**Patentanspruch**

Verfahren zur Herstellung von Reliefkopien, bei dem die photopolymerisierbare Schicht eines Aufzeichnungsmaterials, die eine polymerisierbare Verbindung mit mindestens zwei endständigen ethylenisch ungesättigten Doppelbindungen, ein polymeres Bindemittel und einen Photoinitiator enthält, der bei Belichtung freie Radikale zu erzeugen vermag, bildmäßig belichtet wird und danach die unbelichteten Schichtbereiche mittels eines Entwicklers ausgewaschen werden, dadurch gekennzeichnet, daß man die Schicht nach dem Belichten für 5 Sekunden bis 10 Minuten auf eine Temperatur im Bereich von 50—180° C erwärmt und dann entwickelt.

**Claims**

A process for the production of relief copies, in which the photopolymerizable layer of a copying material, which layer contains a polymerizable compound with at least two terminal ethylenically unsaturated double bonds, a polymeric binder and a photoinitiator which on exposure can generate free radicals, is exposed imagewise and thereafter the unexposed areas of the layer are washed out be means of a developer, characterized in that the layer is warmed for a period of 5 seconds to 10 minutes to temperature within the range from 50 to 180° C after exposure, and is then developed.

**Revendication**

Procédé de production de copies en relief dans lequel on expose selon une image la couche photopolymérisable d'un matériau d'enregistrement, qui contient un composé polymérisable possédant au moins deux doubles liaisons à insaturation éthylénique situées en bout de chaîne, un liant polymère et un photo-initiateur capable de donner naissance à des radicaux libres lors de l'exposition, et ensuite, on élimine les régions de la couche non exposées par lavage au moyen d'un développateur, caractérisé en ce que l'on chauffe la couche pendant 5 secondes à 10 minutes à une température de 50 à 180° C après l'exposition et qu'ensuite on la développe.